(19) Europäisches Patentamt
European Patent Office
Office européen des brevets

(11) **EP 0 995 345 B1**

(12) **FASCICULE DE BREVET EUROPEEN**

(45) Date de publication et mention
de la délivrance du brevet:
**23.07.2008 Bulletin 2008/30**

(51) Int Cl.:
***H05H 1/46*** *(2006.01)*   ***H01J 37/32*** *(2006.01)*

(21) Numéro de dépôt: **98936460.9**

(22) Date de dépôt: **07.07.1998**

(86) Numéro de dépôt international:
**PCT/FR1998/001453**

(87) Numéro de publication internationale:
**WO 1999/004608 (28.01.1999 Gazette 1999/04)**

(54) **DISPOSITIF D'EXCITATION D'UN GAZ PAR PLASMA D'ONDE DE SURFACE**

VORRICHTUNG ZUR ANREGUNG EINES GASES DURCH OBERFLÄCHENWELLENPLASMA

GAS EXCITATION DEVICE WITH SURFACE WAVE PLASMA

(84) Etats contractants désignés:
**DE GB IE IT NL**

(30) Priorité: **16.07.1997 FR 9709025**

(43) Date de publication de la demande:
**26.04.2000 Bulletin 2000/17**

(73) Titulaire: **L'AIR LIQUIDE, Société Anonyme pour l'Etude
et l'Exploitation des Procédés Georges Claude
75007 Paris (FR)**

(72) Inventeurs:
• **MOISAN, Michel
  Outremont, Québec H2V 2Z1 (CA)**
• **ZAKRZEWSKI, Zenon
  PL-80-416 Gdansk (PL)**
• **ETEMADI, Roxane
  Montréal, Québec H3T 1W5 (CA)**

• **ROSTAING, Jean-Christophe
  F-78530 Buc (FR)**

(74) Mandataire: **Vesin, Jacques
  L'AIR LIQUIDE, S.A.,
  Service Propriété Industrielle,
  75, Quai d'Orsay
  75321 Paris Cédex 07 (FR)**

(56) Documents cités:
**EP-A- 0 415 122**       **EP-A- 0 739 155**

• **PATENT ABSTRACTS OF JAPAN vol. 16, no. 219 (C-0943), 22 mai 1992 & JP 04 041675 A (MATSUSHITA EL.), 12 février 1992**
• **MOISAN M ET AL: "The waveguide surfatron: a high power surface-wave launcher to sustain large-diameter dense plasma columns" JOURNAL OF PHYSICS E (SCIENTIFIC INSTRUMENTS), NOV. 1987, UK, vol. 20, no. 11, pages 1356-1361, XP002060541 ISSN 0022-3735**

**Description**

La présente invention est relative à un dispositif d'excitation d'un gaz, du type surfaguide ou surfatron-guide, dans lequel le gaz à exciter est traité par un plasma d'onde de surface, en particulier à pression atmosphérique.

Pour exciter un gaz, on le fait circuler dans un tube diélectrique et l'on entretient dans ce gaz une décharge électrique de préférence hors d'équilibre thermodynamique local au moyen du champ électrique associé à une onde de surface. Celle-ci est excitée par un applicateur de champ qui est lui-même alimenté en puissance micro-onde à partir d'un guide d'ondes classique.

Un premier type d'applicateur connu sous l'appellation surfatron-guide comporte une structure creuse en matériau électriquement conducteur comportant une première partie délimitant une zone de concentration des ondes incidentes et obturée par un piston mobile en guide d'ondes formant court-circuit et une deuxième partie s'étendant perpendiculairement à la première partie et dans laquelle est monté de façon coaxiale un tube en matériau diélectrique dans lequel circule le gaz à exciter. La deuxième partie est munie d'un piston d'accord axialement déplaçable pour l'adaptation de l'impédance du dispositif.

Un autre type connu d'applicateur, connu sous l'appellation surfaguide comporte également une structure creuse formant guide d'ondes, en matériau électriquement conducteur, destinée à être raccordée à un générateur de micro-ondes et munie d'un passage destiné à être traversé par un tube creux diélectrique dans lequel circule le gaz excité. La structure creuse a une forme générale longitudinale et comporte une zone de concentration d'ondes adaptée pour concentrer vers le tube la puissance micro-onde fournie par le générateur, lors du fonctionnement du dispositif, en vue de produire un plasma dans ledit gaz, de préférence un plasma d'onde de surface.

Le surfaguide est dépourvu de piston d'accord tel que celui qui existe au niveau de la deuxième partie du surfatron-guide. Il est donc moins onéreux que ce dernier. En outre, la longueur du plasma créée par le surfaguide est, à puissance égale, un peu plus élevée que celle du plasma créé par le surfatron-guide.

Cependant, dans certaines conditions de fonctionnement, le surfaguide est moins efficace que le surfatron-guide, lorsqu'on utilise des tubes à décharge de diamètre supérieur à 20 mm à la fréquence de 2,45 GHz.

Par ailleurs, pour des puissances de fonctionnement élevées, il apparaît des pertes de rayonnement dans l'environnement du surfaguide, très préjudiciables au bilan énergétique du dispositif et posant en outre des problèmes de fiabilité et de sécurité.

De surcroît, en raison de leur construction, ces deux types de dispositifs excitateurs présentent des rendements de conversion des gaz à traiter relativement limités.

Ainsi, par exemple, pour le $C_2F_6$, le débit maximal de gaz qu'il est possible de détruire à plus de 90% est de l'ordre de 500 cm$^3$ standard par minute (SCCM). Ce débit est insuffisant dans de nombreux cas, par exemple pour effectuer le traitement des effluents gazeux lors du nettoyage de réacteurs de dépôt de couches minces pour la fabrication des dispositifs à semi-conducteurs.

En effet, on observe que l'augmentation du diamètre du tube pour une puissance micro-onde transmise au tube à décharge donnée, pour un débit fixé, conduit au-delà d'une valeur assez faible, à une diminution du rendement de conversion. Ceci s'explique, en particulier, par le fait que l'accroissement du diamètre du tube à décharge réduit l'énergie moyenne des électrons, ce qui diminue l'excitation par impacts électroniques.

Un autre phénomène important lié au diamètre du tube à décharge est celui de la contraction radiale des décharges à pression atmosphérique, que celles-ci soient le résultat d'un champ électrique continu, radiofréquence ou micro-onde. Ce phénomène est d'autant plus marqué que le gaz possède une conductivité thermique faible, comme c'est le cas du krypton.

Dans le cas où la contraction est importante, le plasma apparaît sous forme filamentaire. Dès qu'il y a contraction, le gaz subit de la part de la décharge une action de moins en moins importante au fur et à mesure que l'on s'éloigne de l'axe du tube.

Par conséquent, l'augmentation du diamètre du tube à décharge s'accompagne de la génération d'un ou de plusieurs filaments de plasma entre lesquels le gaz à exciter peut circuler sans subir aucune excitation.

Par ailleurs, pour un débit de gaz donné, il n'est pas possible d'augmenter la puissance transmise à la décharge à onde de surface en vue d'augmenter le rendement de conversion, au-delà d'une valeur limite, sans risquer d'engendrer un arc électrique dans l'interstice de lancement du dispositif.

Le document EP-A-739155 décrit un dispositif d'excitation d'un gaz comprenant une structure creuse en matériau électriquement conducteur formant guide d'ondes destinée à être raccordée à un générateur de micro-ondes, et des moyens pour faire circuler à travers ladite structure le gaz à exciter. Ladite structure, de forme générale longitudinale comporte deux passages ménagés dans la paroi de ladite structure et traversés chacun par un tube creux (3,4)disposés le long de l'axe du guide d'onde.

Le but de l'invention est de pallier les inconvénients des dispositifs de type surfaguide et surfatron-guide de l'état de la technique et de fournir un dispositif excitateur de gaz permettant d'une part d'augmenter le débit de gaz pour un rendement donné et, d'autre part, d'augmenter le rendement pour un débit de gaz donné.

Elle a donc pour objet un dispositif d'excitation d'un gaz comprenant une structure creuse en matériau électriquement conducteur formant guide d'ondes destinée à être raccordée à un générateur de micro-ondes et des moyens pour faire circuler à travers ladite structure le gaz à exciter, ladite structure ayant une forme générale longitudinale et comportant une zone de concentration du rayonnement émis par ledit générateur adaptée pour produire dans le gaz un plasma lors du fonctionnement du dispositif, caractérisé en ce que lesdits moyens pour faire circuler le gaz comportent un ensemble d'au moins deux tubes creux identiques en matériau diélectrique traversant respectivement ladite structure dans des zones dans lesquelles l'amplitude du champ électrique associé à l'onde incidente est maximale, ladite zone de concentration comportant soit un unique passage (76) ménagé dans la paroi de ladite structure et destiné à être traversé par lesdits tubes creux (78), soit une pluralité de passages (50,52) traversés chacun par un tube diélectrique (54,56) disposé par paire le long de l'axe longitudinal (Y-Y') de ladite zone.

On obtient ainsi un dispositif d'excitation pouvant être équipé de plusieurs tubes à décharge dans chacun desquels circule un gaz avec un débit relativement faible, le débit global du gaz à exciter circulant à travers le dispositif étant considérablement augmenté.

Le dispositif d'excitation selon l'invention peut en outre comporter une ou plusieurs des caractéristiques suivantes :

- ladite zone de concentration comporte un ensemble d'au moins deux passages ménagés dans la paroi de ladite structure par rapport à un plan longitudinal de symétrie de celle-ci et destinés chacun à être traversés par un desdits tubes creux ;
- lesdits passages sont ménagés le long dudit plan de symétrie de la structure ;
- lesdits passages sont ménagés le long de deux axes longitudinaux s'étendant de part et d'autre du plan de symétrie de la structure, à égale distance de celui-ci;
- lesdits passages sont disposés par paires le long dudit plan de symétrie, lesdits passages de chaque paire étant disposés de façon symétrique de part et d'autre dudit plan ;
- lesdits passages sont régulièrement ménagés par rapport audit plan de symétrie longitudinal de la structure, la distance entre deux passages considérée parallèlement à la direction longitudinale de ladite structure étant égale à un multiple entier, au moins égal à 1, de la demi longueur d'onde $\lambda_g/2$ caractéristique du guide d'ondes à la fréquence de fonctionnement du dispositif ;
- ladite zone de concentration comporte un unique passage ménagé dans la paroi de ladite structure et destiné à être traversé par lesdits tubes creux ;
- ladite structure creuse formant guide d'ondes comporte une première extrémité ouverte destinée à être raccordée audit générateur de micro-ondes, une extrémité opposée ouverte destinée à être équipée de moyens de réglage d'impédance formant court-circuit et une zone de section rétrécie dans laquelle sont ménagés ledit ou lesdits passages, s'étendant entre lesdites premières et deuxièmes extrémités et délimitant ladite zone de concentration du rayonnement;
- ladite zone de section rétrécie comporte une partie de section constante dans laquelle sont ménagés ledit ou lesdits passages et s'étendant entre deux parties de section linéairement croissante en direction desdites extrémités ;
- le dispositif comporte en outre au moins un manchon en matériau conducteur de blindage électromagnétique solidaire de ladite structure et s'étendant dans le prolongement dudit ou desdits passages de manière à entourer lesdits tubes creux ;
- ledit au moins un manchon a une longueur au moins égale à la longueur du plasma créé dans le gaz;
- l'extrémité libre de chaque manchon porte un flasque équipé d'un trou pour le passage desdits tubes creux;
- ledit au moins un manchon a une longueur égale à la somme de la longueur du plasma et de la longueur d'onde dudit rayonnement micro-onde dans le vide ;
- la paroi dudit au moins un manchon est munie d'au moins un orifice de visualisation du plasma dont les dimensions sont adaptées pour éviter le passage du rayonnement;
- le diamètre du ou de chaque passage est supérieur au diamètre externe desdits tubes creux ;
- le dispositif constitue un excitateur d'onde de surface de type surfaguide ;
- le dispositif constitue un excitateur d'onde de surface de type surfatron-guide.

D'autres caractéristiques et avantages ressortiront de la description suivante, donnée uniquement à titre d'exemple et faite en référence aux dessins annexés sur lesquels :

- la figure 1 est une vue schématique de dessus d'un dispositif d'excitation de l'état de la technique ;
- la figure 2 représente le schéma électrique équivalent du dispositif de la figure 1 ;
- la figure 3 est une vue schématique latérale du dispositif d'excitation selon l'invention ;
- la figure 4 est une vue schématique en perspective d'un dispositif d'excitation selon un autre mode de réalisation ;
- la figure 5 représente une vue en perspective d'un dispositif d'excitation selon un autre mode de réalisation ; et

- la figure 6 montre des courbes du rapport de la puissance réfléchie sur la puissance incidente et de la position effective du piston d'accord au minimum de puissance réfléchie sur la longueur d'onde caractéristiques du guide à 2,45 GHz en fonction du débit de gaz par tube, à une puissance incidente de 500 W, pour un dispositif selon l'invention.

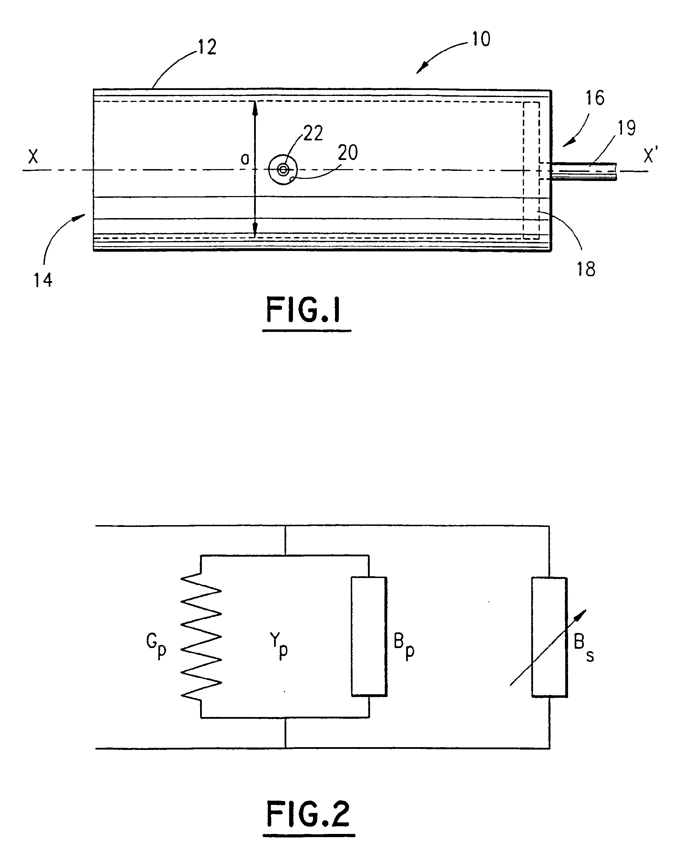

Sur la figure 1, on a représenté une vue schématique de dessus d'un surfaguide de type classique, désigné par la référence numérique générale 10.

Le surfaguide 10 est constitué principalement par une structure creuse 12 formant guide d'ondes réalisée en un matériau électriquement conducteur, munie d'une première extrémité 14 destinée à être connectée à un générateur de micro-ondes (non représenté) et d'une extrémité opposée 16 obturée par une plaque mobile 18 formant court-circuit disposée transversalement par rapport à l'axe longitudinal X-X' de la structure 12.

La plaque 18 est munie d'une tige de manoeuvre 19 raccordée de préférence à des moyens moteurs non représentés. Elle constitue un piston mobile de court-circuit axialement déplaçable par rapport à la structure 12.

La structure creuse 12 est munie d'une zone de concentration des micro-ondes incidentes percée d'orifices transversaux délimitant un passage 20 dans lequel est placé un tube creux 22 en matériau diélectrique s'étendant perpendiculairement à l'axe X-X' et dans lequel circule une colonne de gaz à exciter.

En fonctionnement, le rayonnement micro-onde produit par le générateur de micro-ondes est guidé par la structure 12 qui concentre l'énergie électromagnétique incidente vers le tube 22 de manière à faire se propager dans celui-ci et dans le mélange gazeux qu'il contient une onde électromagnétique progressive de surface dont le champ électrique associé engendre et maintient une décharge dans la colonne de gaz.

Sur la figure 2 on a représenté le circuit électrique équivalent du dispositif de la figure 1, afin d'illustrer les phénomènes de transfert de puissance ayant lieu au niveau de cet applicateur de champ.

On voit sur cette figure que l'excitateur 12 peut être représenté par l'association de deux admittances, $Y_P$ et $Y_S$ disposées en parallèle et correspondant respectivement au plasma engendré dans la colonne de gaz et au piston 18 de court-circuit.

Les différents éléments de ce circuit correspondent aux processus de stockage ou de dissipation de l'énergie électromagnétique se produisant dans les différentes parties du dispositif.

Les admittances $Y_P$ et $Y_S$ sont constituées chacune par l'association en parallèle d'une conductance G, terme associé à la dissipation d'énergie et d'une susceptance B, terme associé au stockage d'énergie et sont définies par les relations suivantes :

$$Y_P = G_P + jB_P \qquad\qquad (1)$$

et

$$Y_S = G_S + jB_S \qquad\qquad (2)$$

Dans la suite de la description, on utilisera les admittances normalisées suivantes :

$$y_P = g_P + jb_P = Y_P/Y_0 \qquad\qquad (3)$$

et

$$y_S = g_S + jb_S = Y_S/Y_0 \qquad\qquad (4)$$

dans lesquelles $Y_0$ représente l'admittance caractéristique du guide d'onde.

On notera que la valeur de l'admittance normalisée $y_P$ dépend de la puissance micro-onde injectée et de l'endroit dans le guide où se situe le tube 22, c'est-à-dire de la densité de champ électrique qui existe à cet endroit.

Par ailleurs, le piston mobile 18 est un élément n'engendrant pas de dissipation d'énergie. Par conséquent, la conductance $g_S$ de ce piston 18 est nulle.

Par ailleurs, la susceptance $b_S$ du piston 18 peut prendre toute valeur entre moins l'infini et plus l'infini lorsque le piston est déplacé sur une demie longueur d'onde $\lambda_g$ caractéristique du guide d'onde à la fréquence considérée de fonctionnement du dispositif.

Cette longueur d'onde $\lambda_g$ est donnée par la relation suivante :

$$\lambda_g = \lambda_0/(1-(\lambda_0/2a)^2)^{1/2} \qquad\qquad (5)$$

dans laquelle :

$\lambda_0$ est la longueur d'onde du rayonnement hyperfréquence dans le vide, et
a est la longueur du grand côté de la section rectangulaire de la structure 12 (figure 1), cette longueur étant relative à la section de guide où se trouve l'orifice 20.

Le terme $b_s$ pouvant prendre toute valeur, il est possible de compenser la susceptance du plasma $b_P$, en réglant la position du piston 18, de sorte que l'admittance normalisée $y_P$ est égale à $g_P$.

Ceci conduit à une valeur minimale de la puissance réfléchie soit :

$$P_R/P_i = |(1-g_P)/(1+g_P)|^2 \qquad\qquad (6)$$

dans laquelle $P_R$ désigne la puissance réfléchie, et $P_i$ désigne la puissance incidente.

Pour que la puissance réfléchie soit voisine de zéro, il faut que la valeur de l'admittance normalisée $y_P$, égale à $g_P$, soit voisine de 1, c'est-à-dire que l'impédance du plasma soit parfaitement adaptée à l'impédance caractéristique du guide.

Il est à noter que la valeur de $g_P$ dépend des propriétés du plasma et de la puissance micro-onde qui lui est transférée pour une composition donnée du mélange gazeux, mais également de la position et de la géométrie de l'interstice de lancement, c'est-à-dire de l'amincissement de la paroi du guide d'onde au voisinage du tube 22, et du diamètre des orifices de passage du tube creux 22.

Lorsque l'accord d'impédance optimal est réalisé, l'onde électromagnétique guidée par la structure 12 a sensiblement la structure d'une onde stationnaire dont les maxima successifs sont distants de $\lambda_g/2$, l'interstice de lancement défini par les orifices de passage du tube étant positionné sur l'un de ces maxima.

Comme cela a été mentionné précédemment, ce type de dispositif muni d'un seul tube présente un certain nombre d'inconvénients, notamment en raison de son rendement limité.

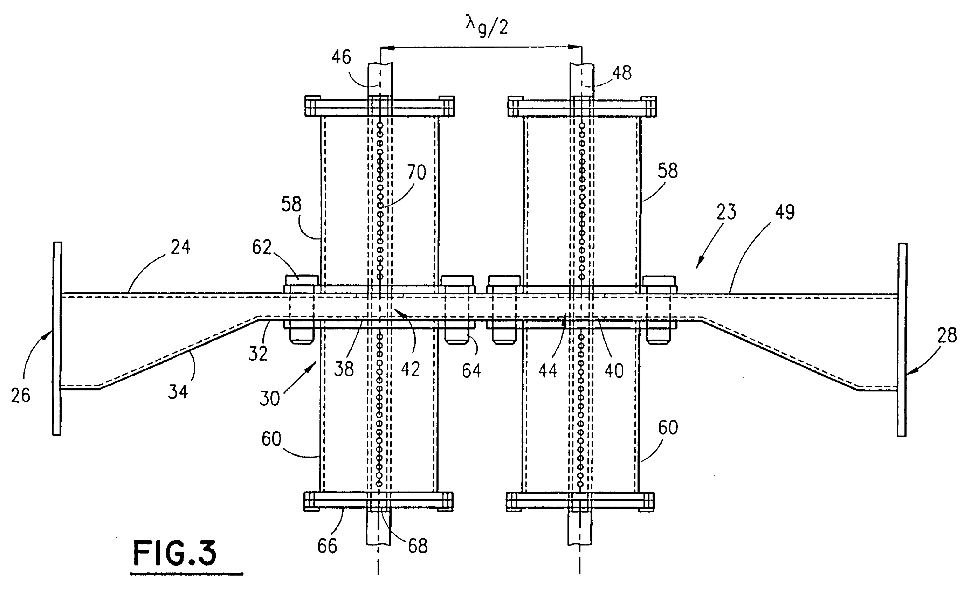

On a représenté sur la figure 3 un dispositif d'excitation permettant de pallier cet inconvénient.

On voit sur la figure 3 que l'excitateur, désigné par la référence numérique 23, comporte une structure creuse 24 de forme longitudinale et réalisée en un matériau électriquement conducteur approprié pour l'utilisation envisagée, en particulier un métal.

La structure creuse 24 a de préférence une section transversale parallélépipédique. Elle présente un plan de symétrie situé dans le plan de la figure 3 et parallèle aux petites faces du guide d'ondes. Elle comporte deux extrémités ouvertes, respectivement 26 et 28 destinées l'une à être raccordée à un générateur de micro-ondes (non représenté) et l'autre à des moyens appropriés pour former un court-circuit ajustable, de préférence une plaque conductrice disposée transversalement et réglable longitudinalement, comme dans le dispositif représenté sur la figure 1.

Entre les deux zones d'extrémité 26 et 28, la structure 24 comporte une zone 30 de section rétrécie comportant une partie médiane 32 de section constante s'étendant entre deux parties 34 et 36 de section linéairement croissante en direction des zones d'extrémité 26 et 28.

On voit également sur la figure 3 que les parois consécutives de la partie médiane 32 sont munies chacune d'orifices, tels que 38 et 40, ces orifices formant des passages, respectivement 42 et 44 pour des tubes 44 et 46 identiques en matériau diélectrique, tel que de la silice, fictivement tronqués sur la figure 3, dans lesquels circule une colonne de gaz à exciter.

Les passages sont disposés dans des zones dans lesquelles l'amplitude du champ électrique associé à l'onde incidente est sensiblement identique lors du fonctionnement du dispositif.

Suivant un premier exemple de réalisation, le dispositif est équipé de deux passages 42 et 44 situés le long du plan de symétrie de la structure 24 c'est-à-dire le long d'un axe longitudinal, constitué par l'intersection de la grande face supérieure 49 de la structure et du plan de symétrie, lesdits passages étant traversés chacun par un tube creux 46 et 48 s'étendant généralement perpendiculairement à l'axe longitudinal.

On conçoit toutefois que le dispositif peut être pourvu d'un nombre supérieur de tels passages en vue de l'augmentation du nombre de tubes pour l'excitation d'un gaz avec un débit supérieur, ces passages étant régulièrement répartis le long du plan de symétrie de la structure 24.

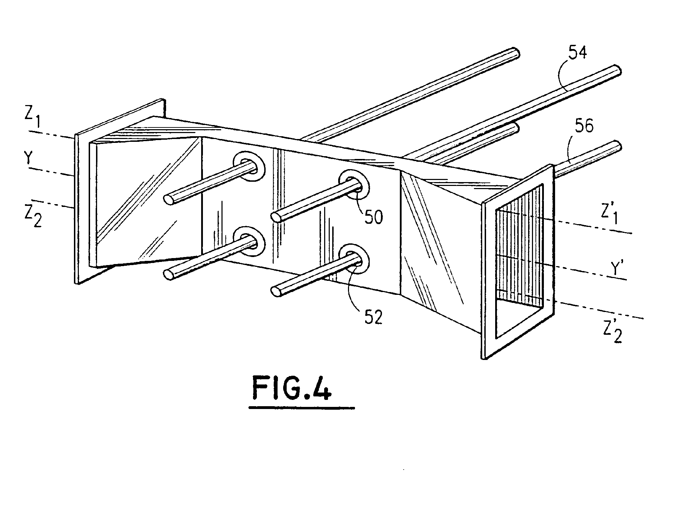

En variante, comme représenté sur la figure 4, il est possible de prévoir des passages, tels que 50 et 52, traversés chacun par un tube diélectrique, tels que 54 et 56, disposés par paires le long du plan de symétrie de la structure, c'est-à-dire le long de l'axe longitudinal Y-Y', les passages 50 et 52 de chaque paire étant disposés de façon symétrique de part et d'autre de ce plan de symétrie le long de deux axes $Z_1$-$Z'_1$ et $Z_2$-$Z'_2$ parallèles.

En se référant à nouveau à la figure 3, on voit que le dispositif comporte en outre, monté sur chacune des grandes faces de la partie médiane 32, des manchons, 58 et 60, en matériau électriquement conducteur, de préférence identique au matériau constitutif de la structure 24. Les manchons sont de préférence cylindriques et placés de façon coaxiale aux passages 42 et 44 formés par les orifices 38 et 40 de manière à entourer les tubes 46 et 48.

On conçoit que ces manchons 58 et 60 doivent être réalisés en un matériau bon conducteur. Il faut en outre que le contact de ces manchons avec la structure 24 soit électriquement excellent. En effet, pour des ondes électromagnétiques circulant dans la structure 24 à une fréquence de l'ordre de 2,45 GHz, toute discontinuité dans la conduction électrique serait susceptible d'offrir un chemin de fuite vers l'extérieur du rayonnement produit par le générateur, même avec un ajustement mécanique très serré.

Ainsi, la structure 24 et les manchons 58 et 60 sont de préférence en laiton de manière à éviter la création dans la zone de fixation de ces pièces d'une couche d'oxyde isolante.

Comme on le voit sur la figure 3, les extrémités des manchons 58 et 60 dans le prolongement l'un de l'autre montées en regard sur le guide d'onde sont équipées chacune d'une platine, telle que 62, ces platines 62 étant serrées contre la partie médiane 32 à l'aide de vis, telles que 64. On obtient ainsi un contact mécanique très étroit des surfaces métalliques.

Par ailleurs, les extrémités libres des manchons 58 et 60 sont équipées chacune d'un flasque, tel que 66, fixé par des techniques appropriées sur celles-ci et munies d'un orifice 68 pour le passage du tube diélectrique 46 et 48 correspondant.

Comme cela sera mentionné par la suite, les flasques 66 peuvent être réalisés en matériau électriquement conducteur, en matériau isolant, ou éventuellement être supprimés en fonction de la longueur des manchons.

On voit enfin sur la figure 3 que la paroi constitutive des manchons 58 et 60 est munie d'orifices 70 permettant la visualisation du plasma dans la colonne de gaz lors du fonctionnement du dispositif.

En fonctionnement, le guide d'onde 24 guide le rayonnement micro-onde incident, provenant du générateur, vers la zone de section rétrécie 30, qui constitue une zone de concentration des micro-ondes, et en particulier vers les tubes diélectriques 46 et 48.

En effet, la zone 30 de section rétrécie concentre l'énergie électromagnétique incidente vers la partie médiane 32 en vue de faire se propager dans les tubes et dans la colonne gazeuse qu'ils contiennent une onde électromagnétique progressive de surface dont le champ électrique associé engendre et maintient un plasma dans la colonne de gaz en vue, comme cela est classique, d'exciter et d'ioniser les particules gazeuses.

Comme précédemment, dans le cas d'un tube unique, lorsque l'accord est réalisé en agissant sur le piston mobile équipant l'extrémité 28 de la structure 24 opposée à l'extrémité 26 raccordée au générateur de micro-ondes, l'admittance normalisée du dispositif est égale à la somme des conductances $g_P$ des tubes.

Lorsque l'admittance est accordée sur l'admittance caractéristique du guide d'onde, éventuellement à l'aide d'un dispositif d'accord supplémentaire afin d'obtenir une puissance réfléchie $P_R$ aussi faible que possible, par exemple un adaptateur à trois plongeurs à vis parallèles de type classique, l'admittance normalisée du dispositif est sensiblement égale à 1. On obtient alors une onde stationnaire dans la structure 24, dont les maxima sont distants de $\lambda_g/2$.

Dans le but d'obtenir un transfert de puissance efficace et égal entre les différents plasmas, les passages 42 et 44 sont ménagés dans la paroi constitutive de la structure 24 à des distances égales à $\lambda_g/2$, le réglage de l'accord étant effectué de manière à faire coïncider l'emplacement de chaque tube avec une zone dans laquelle l'amplitude du champ électrique associé à l'onde incidente dans le guide est maximale en relatif, c'est-à-dire dans une zone dans laquelle la dérivée partielle de la valeur du champ électrique suivant l'axe X-X' s'annule. Dans ce cas, les interstices de lancement formés par les orifices 38 et 40 sont disposés dans des zones dans lesquelles la structure du champ électrique de l'onde incidente est identique. Dès lors, la puissance transférée aux deux plasmas est également identique.

On conçoit donc que cet agencement permet, pour un rendement de conversion donné, d'augmenter considérablement le débit de gaz traité.

Comme cela a été mentionné précédemment, il est possible de doter la paroi d'un ensemble de passages alignés sur l'axe principal du guide et espacés de $\lambda_g/2$ ou, comme représenté sur la figure 4, sur laquelle les manchons ont été supprimés dans un souci de clarté, de disposer plusieurs ensembles de deux orifices situés symétriquement par rapport au plan de symétrie ou à l'axe Y-Y' principal du guide, chaque paire étant espacée de $\lambda_g/2$ le long de cet axe.

Dans ce cas, dans lequel les orifices se situent à une distance x de l'axe principal X-X' du guide d'onde, l'admittance normalisée du plasma est donnée par la relation suivante :

$$g_P \ = \ g_{p0}.\cos^2(\pi x/a) \hspace{3cm} (7)$$

dans laquelle $g_{p0}$ est l'admittance pour un orifice situé dans la même position longitudinale mais sur l'axe principal.

Il est donc également possible, selon ce mode de réalisation, d'optimiser la valeur de l'admittance normalisée du dispositif en disposant à une distance appropriée de l'axe principal Y-Y' les orifices situés en position excentrée, et en agissant sur les moyens de réglage d'impédance.

Il est à noter que pour disposer de davantage de place pour implanter ces orifices excentrés, l'applicateur de champ électrique est de préférence réalisé sur un tronçon de guide de type WR 430 à la fréquence de 2,45 GHz.

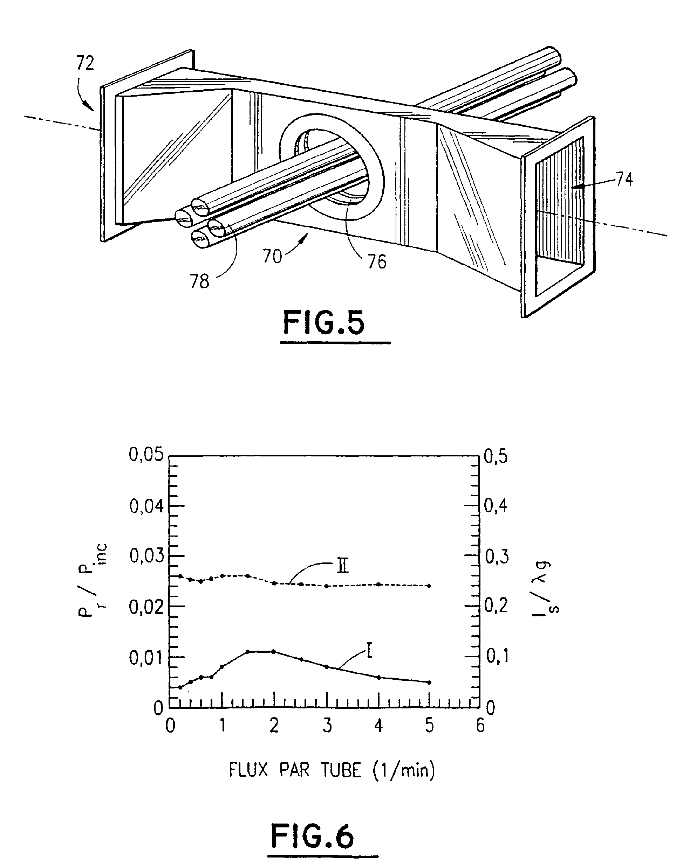

On a représenté sur la figure 5 un autre mode de réalisation du dispositif d'excitation.

Comme dans les exemples de réalisation mentionnés précédemment, ce dispositif comporte également une structure creuse 70 électriquement conductrice munie de deux zones d'extrémité mutuellement opposées 72 et 74 destinées l'une à être raccordée à un générateur de micro-ondes et l'autre à être équipée d'un moyen formant court-circuit.

Comme on le voit sur cette figure, la structure 70 est munie d'un unique passage 76 dans lequel sont disposés plusieurs tubes à décharge, tels que 78, de façon symétrique par rapport à l'axe du passage 76, ces tubes étant par exemple au nombre de quatre.

Le passage 76 est disposé sur l'axe principal de la structure 70, à un emplacement correspondant à un maximum du champ électrique associé à l'onde incidente.

Comme dans les exemples de réalisation décrits précédemment, le dispositif comporte en outre un blindage électromagnétique (non représenté) constitué par un ou deux manchons situés dans le prolongement l'un de l'autre et de structure similaire aux manchons décrits en référence à la figure 3.

Ce mode de réalisation présente l'avantage d'être plus compact et de permettre de concevoir une gaine de fluide de refroidissement commune (non représentée) entourant de façon classique les tubes à décharge 78.

Il est à noter que la paroi externe de chaque tube doit être située relativement près du bord circulaire du passage 76 pour obtenir un couplage énergétique satisfaisant. Le diamètre des orifices constitutifs du passage 76, et donc l'espacement entre les tubes, doit être suffisamment grand pour réduire les interférences entre les ondes de surface excitées sur chacun des tubes à décharge mais doit être suffisamment faible afin de rapprocher les tubes pour favoriser l'équipartition de la puissance entre ces derniers.

Pour augmenter encore le débit de gaz pouvant être traité, il est possible de combiner dans un même dispositif les deux modes de réalisation décrits précédemment, c'est-à-dire en prévoyant plusieurs passages traversés chacun par plusieurs tubes à décharge.

Il est à noter que les différents modes de réalisation décrits en référence aux figures 3 à 5, le diamètre de chacun des manchons doit être choisi suffisamment grand pour ne pas perturber la propagation de l'onde de surface créant la décharge.

Ce choix est dicté par deux considérations.

D'une part, si ce diamètre est trop petit, le champ micro-onde au niveau de la paroi du manchon peut devenir très important, la décroissance du champ électrique associé étant approximativement exponentielle à partir de la paroi du ou des tubes. Ainsi, la conductivité du métal n'étant pas infinie, des pertes par échauffement peuvent apparaître dans la paroi constitutive des manchons, cet échauffement pouvant de plus engendrer une dégradation de ces derniers.

Ainsi, le diamètre minimal dépend de la puissance micro-onde que l'on souhaite injecter dans le plasma, c'est-à-dire des conditions de fonctionnement du dispositif.

Par exemple, dans le mode de réalisation illustré sur la figure 3, dans lequel chaque manchon entoure un unique tube 46, afin de limiter les pertes, le diamètre minimum du manchon est choisi égal au double de celui des tubes.

D'autre part, si le diamètre est trop élevé, la structure du champ électromagnétique peut perdre son caractère d'onde progressive de surface et des couplages de type cavité résonnante se manifester, qui vont rendre le régime de la décharge instable par échange d'énergie entre les modes de cavité et celui de l'onde de surface.

On notera en outre que la longueur des manchons est choisie au moins égale à la longueur du plasma, de sorte que celui-ci soit entièrement compris à l'intérieur des manchons.

Dans le cas où la longueur des manchons n'est que très légèrement supérieure à celle du plasma, les flasques 66 (figure 3) sont de préférence réalisés en matériau électriquement conducteur de manière à éviter que le rayonnement ne s'échappe vers l'extérieur.

Toutefois, comme cela a été mentionné précédemment, ces flasques 66 ne sont pas nécessairement réalisés en matériau conducteur puisque l'intensité du champ micro-onde est faible dans cette région au-delà de la limite du plasma.

En particulier, pour une longueur de manchon égale à la somme de la longueur du plasma et de la longueur d'onde du rayonnement, l'intensité du rayonnement est sensiblement nulle au niveau de la tranche d'extrémité des manchons 58 et 60. Dans ce cas, les flasques 66 peuvent être supprimés.

Par ailleurs, dans les modes de réalisation représentés sur les figures 3 et 4, le diamètre des orifices 38 et 40 délimitant les passages 42 et 44 pour les tubes, ménagés dans la partie constitutive de la partie médiane, a une valeur relativement proche de celle du diamètre externe des tubes, par exemple supérieure au diamètre externe des tubes de 1 ou 2 mm.

Selon une variante avantageuse, le diamètre des passages 42 et 44 est supérieur au diamètre externe des tubes 46 et 48. Par exemple, pour un tube à décharge 46 et 48 ayant un diamètre externe approximativement égal à 15mm, le diamètre du passage est de préférence choisi entre 20 et 22mm, de façon à ménager un interstice entre la paroi constitutive de la partie médiane 32 et le tube 46 et 48.

Selon ce mode de réalisation, la concentration de l'énergie micro-onde est réduite dans l'interstice de lancement du dispositif. On peut donc travailler à des puissances plus élevées afin d'obtenir une meilleure efficacité du dispositif sans risque de dégradation du tube.

On conçoit que l'invention qui vient d'être décrite, selon les différents modes de réalisation, permet d'obtenir de multiples plasmas d'onde de surface à l'aide d'un unique applicateur de champ électrique et donc d'augmenter considérablement le débit maximal admissible de gaz à traiter pour obtenir un rendement d'excitation donné, et ce avec un encombrement relativement faible.

En outre, la configuration compacte et symétrique du dispositif d'excitation procure de très bonnes performances en terme de rendement de transmission de la puissance micro-onde au plasma et d'équipartition de cette puissance entre les plasmas.

On a représenté sur la figure 6 des courbes illustrant, pour le dispositif à deux tubes représenté sur la figure 3, le rapport ($P_R$/Pinc) de la puissance réfléchie sur la puissance incidente (courbe I), ainsi que le rapport de la position effective du piston d'accord $I_s$ au minimum de la puissance réfléchie sur la longueur d'onde caractéristique du guide $\lambda_g$ en fonction du débit par tube (courbe II), avec une puissance incidente totale égale à 500 W.

Cette courbe a été obtenue en utilisant comme gaz à exciter de l'argon pur. Les diamètres externe et interne des tubes à décharge sont respectivement égaux à 7mm et 5mm.

On constate que la puissance réfléchie reste très faible et que la sensibilité des conditions d'accord d'impédance par rapport aux paramètres étudiés de la décharge est très faible pour un tel dispositif d'excitation.

Dans les différents modes de réalisation décrits en référence aux figures 3 et 4, les orifices de passage des tubes à décharge sont disposés en des emplacements correspondant à des maxima le long de l'axe X-X' ou Y-Y' d'une onde stationnaire dans le guide et distants de $\lambda_g$/2 le long de cet axe longitudinal.

Toutefois, il est possible de positionner les orifices de manière à les espacer d'une distance égale à un multiple de $\lambda_g$/2 de façon à n'occuper que certaines des positions correspondant à un maximum.

De même, pour le mode de réalisation représenté sur la figure 4, dans lequel les passages sont disposés le long de deux axes $Z_1$-$Z_1$' et $Z_2$-$Z_2$' parallèles et symétriques par rapport à l'axe principal Y-Y' de la structure, il est possible de distribuer ces passages arbitrairement aux noeuds d'un réseau formé par les deux axes longitudinaux $Z_1$-$Z_1$' et $Z_2$-$Z_2$' et par une série d'axes transverses distants de $\lambda_g$/2.

Bien que ces variantes présentent un encombrement accru, ils sont avantageux dans le cas de l'utilisation de tubes et/ou de manchons de grands diamètres.

En outre, bien que le dispositif d'excitation illustré sur les figures 2 à 4 présente des tubes s'étendant perpendiculairement à l'axe principal de la structure, il est possible, en fonction de l'environnement du dispositif, de positionner ces tubes de façon légèrement inclinée par rapport à cet axe, tout en conservant une configuration symétrique.

Par ailleurs, dans les modes de réalisation décrits précédemment, le dispositif excitateur constitue un applicateur de type surfaguide.

Toutefois un tel dispositif peut utiliser, comme structure de base, un applicateur de type surfatron-guide. On conçoit en particulier que le mode de réalisation décrit dans la figure 5, qui présente un encombrement de tube plus faible, est particulièrement adapté à la construction d'un surfatron-guide, en raison du grand diamètre de l'orifice de passage.

On notera enfin que les excitateurs décrits en référence aux figures 3 à 5 peuvent être utilisés pour réaliser des associations de réacteurs à plasma soit en parallèle, soit en série en rebouclant la sortie d'un tube sur l'entrée d'un autre tube excité par le même applicateur.

**Revendications**

1. Dispositif d'excitation d'un gaz comprenant une structure creuse (24;70) en matériau électriquement conducteur formant guide d'ondes destinée à être raccordée à un générateur de micro-ondes, et des moyens pour faire circuler à travers ladite structure le gaz à exciter, ladite structure (24;70) ayant une forme générale longitudinale et comportant une zone (32) de concentration du rayonnement émis par ledit générateur adaptée pour produire dans le gaz un plasma lors du fonctionnement du dispositif, **caractérisé en ce que** lesdits moyens pour faire circuler le gaz comportent un ensemble d'au moins deux tubes creux (46,48;54,56;78) identiques en matériau diélectrique traversant respectivement ladite structure (24;70) dans des zones dans lesquelles l'amplitude du champ électrique associé à l'onde incidente est maximale; ladite zone de concentration comporte soit un unique passage (76) ménagé dans la paroi de ladite structure et destiné à être traversé par lesdits tubes creux (78), soit une pluralité de passages (50,52) traversés chacun par un tube diélectrique (54, 56) disposés par paire le long de l'axe longitudinal (Y-Y')de ladite zone.

2. Dispositif selon la revendication 1, **caractérisé en ce que** ladite zone de concentration comporte un ensemble d'au moins deux passages (42,44;50,52) ménagés dans la paroi de ladite structure (24) par rapport à un plan de symétrie longitudinal de celle-ci et destinés chacun à être traversés par un desdits tubes creux (46,48;54,56).

3. Dispositif selon la revendication 2, **caractérisé en ce que** lesdits passages (42,44) sont ménagés le long dudit plan de symétrie de la structure.

4. Dispositif selon la revendication 2, **caractérisé en ce que** lesdits passages sont ménagés de part et d'autre du plan de symétrie de la structure creuse (24;70), à égale distance dudit plan de symétrie.

5. Dispositif selon la revendication 2, **caractérisé en ce que** lesdits passages (50,52) sont ménagés le long de deux axes ($Z_1$-$Z'_1$, $Z_2$-$Z'_2$) longitudinaux s'étendant de part et d'autre du plan de symétrie de la structure (24), à égale distance de celui-ci.

6. Dispositif selon la revendication 5, **caractérisé en ce que** lesdits passages (50,52) sont ménagés par paires le long dudit plan de symétrie, lesdits passages de chaque paire étant ménagés de façon symétrique de part et d'autre dudit plan.

7. Dispositif selon l'une quelconque des revendications 1 à 6, **caractérisé en ce que** lesdits passages (42,44;50,52) sont régulièrement ménagés par rapport audit plan de symétrie longitudinal de la structure, la distance entre deux passages (40,42;50,52) considérée parallèlement à la direction longitudinale de ladite structure étant égale à un multiple entier, au moins égal à 1, de la demi longueur d'onde $\lambda_g/2$ caractéristique du guide d'ondes à la fréquence de fonctionnement du dispositif.

8. Dispositif selon l'une quelconque des revendications 2 à 7, **caractérisé en ce que** ladite structure creuse (24,70) formant guide d'ondes comporte une première extrémité ouverte (26;72) destinée à être raccordée audit générateur de micro-ondes, une extrémité opposée (28;74) ouverte destinée à être équipée de moyens de réglage d'impédance formant court-circuit et une zone de section rétrécie dans laquelle sont ménagés ledit ou lesdits passages, s'étendant entre lesdites premières et deuxièmes extrémités et délimitant ladite zone de concentration du rayonnement.

9. Dispositif selon la revendication 8, **caractérisé en ce que** ladite zone de section rétrécie comporte une partie de section constante (32) dans laquelle sont ménagés ledit ou lesdits passages et s'étendant entre deux parties de section linéairement croissante en direction desdites extrémités.

10. Dispositif selon l'une quelconque des revendications 2 à 9, **caractérisé en ce qu'**il comporte en outre au moins un manchon (58,60) en matériau conducteur de blindage électromagnétique solidaire de ladite structure et s'étendant dans le prolongement dudit ou desdits passages de manière à entourer lesdits tubes creux.

11. Dispositif selon la revendication 10,
**caractérisé en ce que** ledit au moins un manchon (58,60) a une longueur au moins égale à la longueur du plasma créé dans le gaz.

12. Dispositif selon l'une des revendications 10 ou 11, **caractérisé en ce que** l'extrémité libre de chaque manchon (58,60) porte un flasque (66) équipé d'un trou (68) pour le passage desdits tubes creux.

**13.** Dispositif selon l'une quelconque des revendications 10 à 12, **caractérisé en ce que** ledit au moins un manchon (58,60) a une longueur égale à la somme de la longueur du plasma et de la longueur d'onde dudit rayonnement micro-onde dans le vide.

**14.** Dispositif selon l'une quelconque des revendications 10 à 13, **caractérisé en ce que** la paroi dudit au moins un manchon (58,60) est munie d'au moins un orifice (70) de visualisation du plasma dont les dimensions sont adaptées pour éviter le passage du rayonnement.

**15.** Dispositif selon l'une quelconque des revendications 2 à 14, **caractérisé en ce que** le diamètre du ou de chaque passage est supérieur au diamètre externe desdits tubes creux.

**16.** Dispositif selon l'une quelconque des revendications 1 à 15, **caractérisé en ce qu'**il constitue un excitateur d'onde de surface de type surfaguide.

**17.** Dispositif selon l'une quelconque des revendications 1 à 16, **caractérisé en ce qu'**il constitue un excitateur d'onde de surface de type surfatron-guide.

**Claims**

**1.** Device for exciting a gas, comprising a hollow structure (24; 70), made of electrically conductive material, which forms a waveguide and is intended to be connected to a microwave generator, and means for passing the gas to be excited through the said structure, the said structure (24; 70) having a longitudinal general shape and including a zone (32) which is intended for concentration of the radiation emitted by the said generator and is designed to produce a plasma in the gas during operation of the device, **characterized in that** the said means for passing the gas include a set of at least two identical hollow tubes (46, 48; 54, 56; 78) made of dielectric material, respectively passing through the said structure (24; 70) in zones where the amplitude of the electric field associated with the incident wave is a maximum; the said concentration zone includes either a single passage (76) which is formed in the wall of the said structure and is intended to have the said hollow tubes (78) pass through it, or a plurality of passages (50, 52) through each of which a dielectric tube (54, 56) passes, the said passages being arranged in pairs along the longitudinal axis (Y-Y') of the said zone.

**2.** Device according to Claim 1, **characterized in that** the said concentration zone includes a set of at least two passages (42, 44; 50, 52) which are formed in the wall of the said structure (24) with respect to a longitudinal plane of symmetry thereof and are each intended to have one of the said hollow tubes (46, 48; 54, 56) pass through them.

**3.** Device according to Claim 2, **characterized in that** the said passages (42, 44) are formed along the said plane of symmetry of the structure.

**4.** Device according to Claim 2, **characterized in that** the said passages are formed on either side of the plane of symmetry of the hollow structure (24; 70), equidistant from the said plane of symmetry.

**5.** Device according to Claim 2, **characterized in that** the said passages (50, 52) are formed along two longitudinal axes ($Z_1$-$Z'_1$, $Z_2$-$Z'_2$) extending on either side of the plane of symmetry of the structure (24), equidistant from this plane.

**6.** Device according to Claim 5, **characterized in that** the said passages (50, 52) are formed in pairs along the said plane of symmetry, the said passages in each pair being formed symmetrically on either side of the said plane.

**7.** Device according to any one of Claims 1 to 6, **characterized in that** the said passages (42, 44; 50, 52) are formed regularly with respect to the said longitudinal plane of symmetry of the structure, the distance between two passages (40, 42; 50, 52), considered parallel to the longitudinal direction of the said structure, being equal to an integer multiple, at least equal to 1, of the half-wavelength $\lambda_g/2$ characteristic of the waveguide at the operating frequency of the device.

**8.** Device according to any one of Claims 2 to 7, **characterized in that** the said hollow structure (24, 70) which forms a waveguide has a first open end (26; 72), intended to be connected to the said microwave generator, an open opposite end (28; 74), intended to be equipped with impedance adjustment means forming a short-circuit, and a zone of narrowed cross-section, in which the said passage or passages are formed, which extends between the said first and second ends and delimits the said radiation concentration zone.

9. Device according to Claim 8, **characterized in that** the said zone of narrowed cross-section has a part (32) with constant cross-section, in which the said passage or passages are formed and which extends between two parts with cross-section increasing linearly in the direction of the said ends.

10. Device according to any one of Claims 2 to 9, **characterized in that** it furthermore includes at least one electromagnetic screening sleeve (58, 60) made of conductive material, secured to the said structure and extending in continuation of the said passage or passages so as to surround the said hollow tubes.

11. Device according to Claim 10, **characterized in that** the said at least one sleeve (58, 60) has a length at least equal to the length of the plasma created in the gas.

12. Device according to one of Claims 10 and 11, **characterized in that** the free end of each sleeve (58, 60) bears a flange (66) equipped with a hole (68) for 10 passage of the said hollow tubes.

13. Device according to any one of Claims 10 to 12, **characterized in that** the said at least one sleeve (58, 60) has a length equal to the sum of the length of the plasma and the wavelength of the said microwave radiation in vacuo.

14. Device according to any one of Claims 10 to 13, **characterized in that** the wall of the said at least one sleeve (58, 60) is provided with at least one orifice (70) for viewing the plasma, the dimensions of which are designed to prevent passage of the radiation.

15. Device according to any one of Claims 2 to 14, **characterized in that** the diameter of the or each passage is greater than the external diameter of the said hollow tubes.

16. Device according to any one of Claims 1 to 15, **characterized in that** it constitutes a surface-wave exciter of the surfaguide type.

17. Device according to any one of Claims 1 to 16, **characterized in that** it constitutes a surface-wave exciter of the surfatron-guide type.


**Patentansprüche**

1. Vorrichtung zur Gasanregung, umfassend eine Hohlstruktur (24; 70) aus einem elektrisch leitenden Material, die einen Wellenleiter bildet und dazu gedacht ist, an einen Mikrowellengenerator angeschlossen zu werden, und Mittel, um das anzuregende Gas durch die Struktur fließen zu lassen, wobei die Struktur (24; 70) eine im Allgemeinen längliche Form aufweist und einen Bereich (32) umfasst zum Konzentrieren der Strahlung, die von dem Generator abgestrahlt wird, wobei der Bereich dazu geeignet ist, während des Betriebs der Vorrichtung im Gas ein Plasma zu erzeugen, **dadurch gekennzeichnet, dass** die Mittel zum Fließenlassen des Gases eine Einheit aus mindestens zwei identischen Hohlröhren (46, 48; 54, 56; 78) aus einem dielektrischen Material umfassen, die jeweils die Struktur (24; 70) in Bereichen durchqueren, in denen die Amplitude des elektrischen Felds, das mit der einfallenden Welle verbunden ist, am größten ist; wobei der Konzentrationsbereich entweder einen einzigen Durchgang (76), der in der Wand der Struktur eingerichtet ist und dazu gedacht ist, von den Hohlröhren (78) durchquert zu werden, oder eine Vielzahl von Durchgängen (50, 52), die jeweils von einer dielektrischen Röhre (54, 56) durchquert werden, umfasst, die paarweise an der Längsachse (Y-Y') des Bereichs entlang angeordnet sind.

2. Vorrichtung nach Anspruch 1, **dadurch gekennzeichnet, dass** der Konzentrationsbereich eine Einheit von mindestens zwei Durchgängen (42, 44; 50, 52) umfasst, die in der Wand der Struktur (24) im Verhältnis zu einer Längssymmetrieebene davon eingerichtet und jeweils dazu gedacht sind, von einer der Hohlröhren (46, 48; 54, 56) durchquert zu werden.

3. Vorrichtung nach Anspruch 2, **dadurch gekennzeichnet, dass** die Durchgänge (42, 44) an der Symmetrieebene der Struktur entlang eingerichtet sind.

4. Vorrichtung nach Anspruch 2, **dadurch gekennzeichnet, dass** die Durchgänge auf beiden Seiten der Symmetrieebene der Hohlstruktur (24; 70) im gleichen Abstand zur Symmetrieebene angeordnet sind.

**5.** Vorrichtung nach Anspruch 2, **dadurch gekennzeichnet, dass** die Durchgänge (50, 52) an zwei Längsachsen ($Z_1$-$Z'_1$, $Z_2$-$Z'_2$) entlang eingerichtet sind, die sich auf beiden Seiten der Symmetrieebene der Struktur (24) im gleichem Abstand dazu erstrecken.

**6.** Vorrichtung nach Anspruch 5, **dadurch gekennzeichnet, dass** die Durchgänge (50, 52) paarweise an der Symmetrieebene entlang eingerichtet sind, wobei die Durchgänge jedes Paars symmetrisch auf beiden Seiten der Ebene eingerichtet sind.

**7.** Vorrichtung nach einem der Ansprüche 1 bis 6, **dadurch gekennzeichnet, dass** die Durchgänge (42, 44; 50, 52) im Verhältnis zur Längssymmetrieebene der Struktur regelmäßig eingerichtet sind, wobei der Abstand zwischen zwei Durchgängen (40, 42; 50, 52), parallel zur Längsrichtung der Struktur gesehen, gleich einem ganzzahligen Vielfachen, mindestens gleich 1, der charakteristischen Halbwellenlänge $\lambda_g/2$ des Wellenleiters auf der Betriebsfrequenz der Vorrichtung ist.

**8.** Vorrichtung nach einem der Ansprüche 2 bis 7, **dadurch gekennzeichnet, dass** die Hohlstruktur (24, 70), die den Welleleiter bildet, ein erstes offenes Ende (26; 72), das dazu gedacht ist, an den Mikrowellengenerator angeschlossen zu werden, ein entgegengesetztes offenes Ende (28; 74), das dazu gedacht ist, mit Mitteln zur Impedanzeinstellung, die einen Kurzschluss bilden, versehen zu werden, und einen Bereich mit verengtem Querschnitt, in dem der Durchgang bzw. die Durchgänge eingerichtet ist/sind und der sich zwischen den ersten und zweiten Enden erstreckt und den Bereich zum Konzentrieren der Strahlung begrenzt, umfasst.

**9.** Vorrichtung nach Anspruch 8, **dadurch gekennzeichnet, dass** der Bereich mit verengtem Querschnitt einen Teil mit konstantem Querschnitt (32) umfasst, in dem der Durchgang bzw. die Durchgänge eingerichtet ist/sind und der sich zwischen zwei Teilen mit linear in Richtung auf die Enden wachsendem Querschnitt erstreckt.

**10.** Vorrichtung nach einem der Ansprüche 2 bis 9, **dadurch gekennzeichnet, dass** sie außerdem mindestens eine Hülse (58, 60) aus einem leitenden Material zur elektromagnetischen Abschirmung umfasst, die mit der Struktur einstückig ist und sich in der Verlängerung des Durchgangs bzw. der Durchgänge erstreckt, um die Hohlröhren zu umgeben.

**11.** Vorrichtung nach Anspruch 10, **dadurch gekennzeichnet, dass** die mindestens eine Hülse (58, 60) eine Länge aufweist, die mindestens gleich der Länge des im Gas geschaffenen Plasmas ist.

**12.** Vorrichtung nach einem der Ansprüche 10 oder 11,
**dadurch gekennzeichnet, dass** das freie Ende jeder Hülse (58, 60) einen Flansch (66) trägt, der mit einem Loch (68) für den Durchgang der Hohlröhren ausgestattet ist.

**13.** Vorrichtung nach einem der Ansprüche 10 bis 12, **dadurch gekennzeichnet, dass** die mindestens eine Hülse (58, 60) eine Länge aufweist, die gleich der Summe aus der Länge des Plasmas und der Wellenlänge der Mikrowellenstrahlung im luftleeren Raum ist.

**14.** Vorrichtung nach einem der Ansprüche 10 bis 13, **dadurch gekennzeichnet, dass** die Wand der mindestens einen Hülse (58, 60) mit mindestens einer Öffnung (70) zur Betrachtung des Plasmas versehen ist, deren Abmessungen angepasst sind, um den Durchgang der Strahlung zu vermeiden.

**15.** Vorrichtung nach einem der Ansprüche 2 bis 14, **dadurch gekennzeichnet, dass** der Durchmesser des bzw. jedes Durchgangs größer ist als der Außendurchmesser der Hohlröhren.

**16.** Vorrichtung nach einem der Ansprüche 1 bis 15, **dadurch gekennzeichnet, dass** sie einen Oberflächenwellenerreger der Surfaguide-Art bildet.

**17.** Vorrichtung nach einem der Ansprüche 1 bis 16, **dadurch gekennzeichnet, dass** sie einen Oberflächenwellenerreger der Surfatron-Guide-Art bildet.

## FIG.1

## FIG.2

**FIG.3**

**FIG.4**

**FIG.5**

FLUX PAR TUBE (1/min)

**FIG.6**

**EP 0 995 345 B1**

## RÉFÉRENCES CITÉES DANS LA DESCRIPTION

**Documents brevets cités dans la description**

- EP 739155 A